# EUROPEAN PATENT SPECIFICATION

(11) **EP 0 562 618 B1**
(45) Date of publication and mention of the grant of the patent: **03.06.1998**
(21) Application number: 93105034.8
(22) Date of filing: 26.03.1993
(51) Int. Cl.: H01L 39/24

(54) **Oxide superconductor having large magnetic levitation force and its production method**
Oxidsupraleiter mit grosser magnetischer Schwebekraft und Verfahren zu seiner Herstellung
Supraconducteur d'oxyde ayant une grande force de lévitation magnétique et méthode pour sa fabrication

(30) Priority: 27.03.1992 JP 101953/92; 27.03.1992 JP 101955/92; 06.04.1992 JP 113023/92; 19.06.1992 JP 161371/92
(43) Date of publication of application: 29.09.1993
(60) Divisional application: 97118391.8
(73) Proprietor: INTERNATIONAL SUPERCONDUCTIVITY TECHNOLOGY CENTER, Tokyo 105-0004 (JP); KAWASAKI JUKOGYO KABUSHIKI KAISHA, Chuo-ku, Kobe-shi, Hyogo-ken (JP); HOKURIKU ELECTRIC POWER COMPANY, Toyama-ken (JP); NIPPON STEEL CORPORATION, Chiyoda-ku Tokyo-to (JP); RAILWAY TECHNICAL RESEARCH INSTITUTE, Kokubunji-shi Tokyo (JP)
(72) Inventor: KONDOH, Akihiro, Hyogo-ken (JP); Murakami, Masato, Tokyo-To (JP); Koshizuka, Naoki, Tokyo-To (JP); Tanaka, Shoji, Tokyo-To (JP); Kagiya, Shoichi, Tokyo-To (JP); Fujimoto, Hiroyuki, Tokyo-To (JP)
(74) Representative: Hassler, Werner, Dr.

(56) References cited:
- EP-A- 0 292 126
- ZEITSCHRIFT FÜR METALLKUNDE vol. 82, no. 9, September 1991, BERLIN, DE pages 731 - 736 M ller P. et al 'Supraleitende Eigenschaften und Struktur von goldhaltigen YBa2Cu3Ox-Kerndraehten mit Ag-Mantel'
- APPLIED PHYSICS LETTERS vol. 56, no. 24, 11 June 1990, NEW YORK, US pages 2459-2461 KAMMLOT G.W. et al 'Recovery of 90 K superconductivity in transition-metal-doped Y-Ba-Cu-O'
- PHISICA C, vol. 185-189, pt.4, 1 December 1991, pages 2409-2410, Amsterdam, NL; Yoshida M. et al "Effects of the platinum group element addition on preparation of YBCO superconductor by melt growth method"
- PHYSICA C vol. 166, no. 5, 1 April 1990, AMSTERDAM, NL pages 408 - 412 Tiefel T.H. et al 'Recovery of high-Tc superconductivity in Y-Ba-Cu-O doped with reacting metals'

## Description

### BACKGROUND OF THE INVENTION

### - Field of the Invention -

The present invention relates generally to a novel REBaCuO oxide superconductor and its production method and, more particularly, to an oxide superconductor having large magnetic levitation force, which is intended for application to flywheels, magnetic bearings, delivery systems, etc., due to magnetic levitation and its production method. Throughout the disclosure, RE stands for a rare earth element or elements selected from the group consisting of Y, Sm, Eu, Gd, Dy, Ho, Er, and Yb.

### - Prior Art -

In recent years, REBaCuO superconducting oxides have started to be used for application to flywheels, etc., by magnetic levitation. These superconductors, for instance, have been fabricated by the melt powder melt growth (MPMG) technique - see H. Fujimoto and co-workers, "Proc. of ISS '89", Springer - Verlag, p. 285, 1990.

Set out just below is one typical example of superconductor production by this technique. First, the raw materials, e.g., Y₂O₃, BaCO₃ and CuO, are mixed together at a predetermined ratio. The mixture may have been calcined and pulverized. Further, the mixture is heated to a temperature at which RE₂O₃ and liquid phases coexist, e.g., 1,400°C for partial melting (M). Subsequently, the melt is cooled for solidification. This is followed by pulverization (P), mixing, and shaping. The shaped body is then heated to a temperature at which an RE₂BaCuO₅ phase (hereinafter referred to simply as the 211 phase) and a liquid phase coexist, e.g., 1,100°C for partial melting (M). After this, the partial melt is cooled to a temperature at which a superconducting REBa₂Cu₃O_{d} phase (hereinafter simply called the 123 phase) occurs, from which it is slowly cooled at a predetermined rate, e.g., 1°C per hour, thereby forming and growing (G) the 123 phase for superconductor production.

A superconductor fabricated with the use of this technique shows a high critical current density, and exhibits large magnetic levitation force as well, due to large superconducting crystal size - see M. Murakami and co-workers, "Japanese Journal of Applied Physics", Vol. 29, No. 11, p. 1991, 1990. In order to achieve high magnetic levitation force, it is thus required to increase the size of superconducting crystals having high critical current densities.

The high critical current density mentioned above has been achieved by dispersing the 211 phase finely throughout the 123 phase. According to some report, the smaller the 211 phase size, the higher the critical current density is - see M. Murakami and co-workers, "Proc. of M²S HTSC III Conference", 1991. Thus, to disperse the 211 phase throughout the 123 phase and to decrease the size of the 211 phase can provide one important means for obtaining high critical current densities.

However, the MPMG technique involves the steps of heating the raw materials for partial melting, cooling the melt, followed by pulverization and mixing, shaping the mixture, heating the shaped body for partial melting, and slowly cooling the melt for superconductor production. Thus, this process is lengthy and complicated, and so there is strong demand for simplifying it.

So far, such superconductors have also been produced by other techniques such as the MTG (melt textured growth) technique - see S. Jin and co-workers, "Appl. Phys. Lett.", Vol. 52, No. 207, 1988. Set out just below is one typical example of superconductor production by the MTG technique. First, the raw powders are formulated into a composition REBa₂Cu₃O_{d}, followed by shaping. The shaped body is partially melted, and then slowly cooled with some temperature gradient for superconducting phase growth. After this, the superconducting phase is annealed in an oxygen-enriched atmosphere, thereby adding oxygen to the superconducting phase. However, the thus produced superconductor is found to have a low critical current density and so fail to achieve high-enough magnetic levitation force.

Recently, N. Ogawa and co-workers have also come up with the PDMG (platinum doped melt growth) technique making use of the addition of platinum or Pt - see "Physica C177", p. 101, 1991. Set out just below is one typical example of superconductor production by the PDMG technique. First, platinum or a platinum compound (P) is added (D) to the raw powders, when they are mixed together. Following this, the mixture is shaped. Then, the shaped body is partially melted (M) according to the rear MG part of the MPMG technique mentioned above for the growth (G) of the 123 phase. The superconductor fabricated by this PDMG technique has a structure in which the 211 phase is finely dispersed throughout the 123 phase, and shows a high critical current density. With this technique, however, it is difficult to increase superconductor crystal size; in other words, no considerable increase in magnetic levitation force is still achievable.

According to some report, the addition of silver leads to an increase in superconducting crystal size. However, the crystal size is at most 0.5 mm - see C. Y. Huang and co-workers, "Modern Physics Letters B", Vol. 3, No. 6, p. 525, 1989.

N. Ogawa and co-workers have recently come up with the addition of cerium oxide to the raw materials - see "ISS '91 PROGRAM & ABSTRACTS". Set out just below is a typical example of superconductor production by this method. First, cerium oxide is added to the raw powders, when they are mixed together. Following this, the mixture is shaped. Then, the shaped body is partially melted according to the MG technique that is a rear part of the MPMG technique for the growth of the 123 phase. The thus produced superconductor is found to have an improved critical current density. A grave problem with this method, however, is that some considerable difficulty is involved in increasing the size and, hence, magnetic levitation force of superconductor crystals, because it is impossible to place the formation and growth of superconductor crystals, i.e., the 123 phase under control.

According to some report, another recently developed method for increasing superconductor crystal size or the QMG (quench and melt growth) technique - see M. Murakami and co-wdrkers, "Japanese Journal of Applied Physics", Vol. 28, No. 7, 1988 - has well succeeded in achieving crystal size increases by seeding a SmBa₂Cu₃O_{d} single crystal - that is produced by the QMG technique and then cleaved - in precursor - to which a Yb-Y composition gradient is imparted with a Yb₁₋ₓYₓBa₂Cu₃O_{d} composition - at around 1,030°C (in the cooling process from the partial melting to the initiation of the slow cooling for forming and growing the superconducting phase). For this, see M. Morita and co-workers, "Proc. of ISS '90", Springer-Verlag, p. 733, 1991. A patent specification directed to this method has already been published for public inspection (under No. WO91/19029). However, this method is unfit for mass production, because much time and labor are needed for fabricating the precursor having a composition gradient, producing the above seed single crystal, and placing it on the precursor.

*"Zeitschrift für Metallkunde", Vol. 82, No. 9, September 1991, pp. 731 -736 discloses an YBaCuO superconducting wire 5 to 25 wt % Au in the core and a Ag sheet. The Ag of the sheet is diffused into the wire forming an Au/Ag solid solution network. The transition temperature and critical current density of the superconductor have been increased.*

*EP-A- 0 292 126 discloses an YBaCuO superconducting wire comprising Ag powder for improving the critical temperature and the fracture strength whereby the electrical properties are unchanged.*

*"Physica C", Vol. 185 - 189, Part IV, December 1991, pp. 2409 - 2410 discloses an YBCO superconductor comprising finely dispersed 211 particles and 0,5 wt% Pt or Rh additives which increase the critical current density. This effect is achieved by the finely dispersed 211 particles.*

It is thus desired to develop a superconductor having large critical current density and magnetic levitation force, which can be produced by a process shorter and simpler than the MPMG process, and its production process.

In some applications, large superconductor pellets are desired, and so there is strong demand for establishing methods for fabricating such large pellets.

A superconductive material, on the other hand, often presents problems in connection with its thermal stability or mechanical properties.

A superconductive material having unfavorable thermal stability poses the following problem; when it is locally converted into a normal conductor for some unknown reasons to generate heat, it is impossible to remove this heat rapidly by external cooling. This then allows the superconductor to have normal conductivity as a whole and thereby lose its superconductivity. To ward off this, it is desired to improve the thermal stability.

An oxide superconductor, because of being a sort of ceramics, poses a problem in connection with cracking, basically because its toughness is low. The 211 phase dispersed throughout the 123 phase is prima facie effective for inhibiting cracking, but the effect on cracking inhibition is much less than satisfactory, because the 211 phase itself is a ceramic material. Thus, it is desired to improve the mechanical properties.

An object of the present invention is to provide a method that can produce a crack-free superconductor having large magnetic levitation force and having a large crystals and a fine structure in which a phase formed by the above 211 phase and an additive is finely dispersed in the above 123 phase or a superconductor in which the size of the 211 phase dispersed throughout the above 123 phase is reduced and which has a large critical current density, by a process shorter and simpler than the MPMG technique mentioned above and such a superconductor.

The fundamental features of the present invention will be described below in order to achieve the above object.
1) It has been found that when a (Pt,Rh) (Ag,Au) alloy is added as an additive to a starting material, a superconductor having large magnetic levitation force, that is, a superconductor having large crystals and a fine structure in which an alloy comprising the above additive is finely and uniformly dispersed, can be produced by short and simple steps.
2) Further, it has also been found that, when a mixture of cerium oxide and one element from the group consisting of silver, silver oxide, gold or an alloy of silver and gold, are added as an additive to a starting material, a superconductor having large magnetic levitation force, that is, a crack- free superconductor having large crystals and a fine structure in which a phase formed from the above 123 phase and the additive is finely and uniformly dispersed.

In view of a starting material and additive, the present invention includes the following superconductor and methods for producing the same.

### SUMMARY OF THE INVENTION

More specifically, the present invention relates to an REBaCuO oxide superconductor, according to claim 1.

The present invention also relates to a method for producing an REBaCuO oxide superconductor, according to claim 9.

It has been found that a superconductor produced using the additives shown has improved the above thermal stability and mechanical properties thereof. That is, since silver, a main component of the additives, is excellent in thermal conductivity, it is possible to improve the thermal conductivity of a superconductor. When the thermal conductivity is high, it is possible to shorten a cooling time. Further, since distortion can be relieved by deformation of silver or gold that is a metal rather than by the deformation of dispersed ceramics, some considerable improvements in the mechanical properties are achievable.

### BRIEF DESCRIPTION OF THE DRAWINGS

The features of the invention which are believed to be novel are particularly pointed out and distinctly claimed in the concluding portion of this specification. However, the invention may be best appreciated by reference to the following detailed description taken in conjunction with the drawings, in which:
Figure 1 is a graphical representation showing the relation of the amount of the additives having Pt_{0.05}Ag_{0.95} and Pt_{0.20}Ag_{0.80} compositions and the magnetic levitation force of the obtained superconductors,
FIGURE 2 is a graphical representation showing the relation between varying contents of platinum in the additives and the magnetic levitation force of the superconductors obtained in the absence of platinum and/or silver,
FIGURE 3 is a graphical representation of the content of Rh in the additive having the constitutional formula (Ph_{1-y}Pt_{y})_{0.03}Ag_{0.97} and the magnetic levitation force of the resultant superconductors,
FIGURE 4 is a graphical representation showing the relation between the content of Au in the additive having the constitutional formula Pt_{0.05}(Au_{*z*}Ag_{1-z}) and the magnetic levitation force of the resultant superconductors,
FIGURE 5 is a polarized micrograph of the structure of the superconductor obtained in Example 1 of the invention,
FIGURE 6 is a polarized micrograph of the structure of the superconductor obtained in Example 11 of the invention,
FIGURE 7 is a sketch of the superconductor pellet obtained with the addition of 0.5% by weight of cerium oxide alone in Comparative Example 2,
FIGURE 8 is a sketch of the superconductor pellet obtained in Example 15 of the invention,
FIGURE 9 is a sketch showing the structure of the superconductor pellet obtained in Example 15 of the invention,
FIGURE 10 is a graphical representation showing the relation between the content of silver and the magnetic levitation force of the superconductors produced with the addition of 0.5% by weight of cerium oxide and various amounts of silver in Example 15,
FIGURE 11 is a graphical representation showing the content of cerium oxide and the magnetic levitation force of the superconductors obtained with the addition of 10% by weight of silver and various amounts of cerium oxide in Example 15,
FIGURE 12 is a graphical representation showing the relation between the value of u in the constitutional formula AuᵤAg₁₋ᵤ and the magnetic levitation force of the superconductors produced with the addition of 0.5% by weight of cerium oxide and 10% by weight of an alloy having the above formula in Example 18,

### DETAILED DESCRIPTION OF THE PREFERRED EMBODIMENTS

Set out just below is one typical example of the process of the method for superconductor production according to the invention.

### Step 1

At the first step for REBaCuO superconductor production, the precursor prior to shaping is prepared. As RE, at least one rare earth element selected from the group consisting of Y, Sm, Eu, Gd, Dy, Ho, Er, and Yb is used. The raw powders are mixed or the additive mentioned above are added to and mixed with the raw powders to prepare the starting feed.

### First Aspect

The raw materials used in the first aspect of the invention, as is the case with the second aspect of the invention to be described later, may be RE₂O₃, BaCuO₂, BaO₂, CuO, RE₂BaCuO₅, REBa₂Cu₃O_{d}, or the like.

The additive used in the first aspect of the invention basically comprises platinum and silver, and may be expressed by the formula PtₓAg₁₋ₓ. It is noted, however, that silver Ag may be replaced by rhodium in the range of 0 to 100% by weight, and that silver Ag may again be replaced by gold Au in the range of 0 to 100% by weight. Thus, the additive according to the first aspect of the invention comprises platinum and/or rhodium, and may be represented by the constitutional formula (Rh_{y}Pt_{1-y})(Au_{z}Ag_{1-z}). Here, it is preferable that x lies in the range of 0.02 to 0.30 by weight, and y and z each lies in the range of 0 to 1.00, as already noted.

According to the first aspect of the invention, a platinum compound, e.g., Pt₂Ba₄CuO₉, may be used in place of platinum and a silver compound, e.g., Ag₂O instead of silver.

According to the first aspect of the invention, the additive having the above formula may be used with the starting feed in an amount lying in the range of 0.3 to 25.0% by weight.

As is the case with the second aspect of the invention to be described later, a mixture of the raw materials with the above additive that have been calcined and pulverized may be used as the starting feed.

Alternatively, the above additive is added to and mixed with the raw materials, as in the case of the MPMG technique. The mixture is partially melted and cooled for solidification. The solid body is then pulverized and mixed together. The thus obtained mixture may be used as the starting feed.

The above partial melting for the mixture is carried out at a temperature lying in the range of 950 to 1,500°C for 1 to 60 minutes, whereby the RE₂O₃ phase and a liquid phase (made up of oxides of Ba and Cu), or the 211 and liquid phases are formed, and the above cooling is well achieved by a cooling rate that equals or exceeds that of furnace cooling. In the present disclosure, the term "furnace cooling" is understood to mean that the product is permitted to cool as the furnace cools.

### Second Aspect

The additive used in the second aspect of the invention is a cerium oxide and silver, silver oxide, gold, or an alloy of silver and gold, and is preferably added in the amount of 0.1 to 2.0% by weight, calculated as cerium oxide in the case of the cerium oxide. The cerium oxide, for instance, may be CeO₂ and BaCeO₃.

However, of the silver and gold mentioned above, the silver is basically used, but this Silver (Ag) may be replaced by gold (Au) in the range of 0 to 100% by weight. In other words, this may be represented by the constitutional formula AuᵤAg₁₋ᵤ where u lies in the range of 0 to 1.0. These may be added in an amount of 1.0 to 25.0% by weight.

In the composition of the raw materials except the additive, it is preferable that the 211 phase deviates excessively from the stoichiometric 123 phase. This is to disperse the 211 phase in the form of a non-superconductive phase and thereby increase magnetic levitation force. It is here preferable that the 211 phase is in a 5 to 60 mol% excess.

It is then possible to better critical current densities by the addition of 0.1 to 2% by weight of platinum or a platinum compound, 0.01 to 2% by weight of rhodium, or 0.1 to 2% by weight of a cerium oxide. The platinum compound used, for instance, may be Pt₂Ba₄CuO₉, and the cerium oxide used, for instance, may be CeO₂, and CeBaO₃.

### Step 2

The powder mixture obtained at Step 1 is shaped into a desired shape to make a formed body.

When a large, or a rectangular or other body is made, it is preferable that the mixture is first pre-shaped at a relatively low pressure and then isotropically pressed at a good-enough pressure. This is because the body being shaped is prevented from cracking, which may otherwise result in a decrease in the magnetic levitation force of the produced superconductor. In other words, it has now been found that the body being shaped can be ketp from cracking by isotropic pressing.

### Step 3

Powders or single crystals are placed or embedded as the nucleants somewhere on or in the shaped body, as desired. For embedding, the nucleants may be located somewhere in the shaped body. This step may be done anytime until just before the start of slow cooling or the next step 4. However, this should preferably be done here, because it then takes less time and labor.

On the other hand, the nucleants can produce its own effect sufficiently in an amount of at most about 10 mg. The nucleants used, for instance, may be at least one member selected from the group consisting of Y₂O₃, Nd₂O₃, Sm₂O₃, Eu₂O₃, La₂O₃, Gd₂O₃, Dy₂O₃, Ho₂O₃, Er₂O₃, Y₂BaCuO₅, Sm₂BaCuO₅, Eu₂BaCuO₅, Gd₂BaCuO₅, Dy₂BaCuO₅, Ho₂BaCuO₅, Er₂BaCuO5, YBa₂Cu₃O_{d}, NdBa₂Cu₃O_{d}, LaBa₂Cu₃O_{d}, EuBa₂Cu₃O_{d}, GdBa₂Cu₃O_{d}, DyBa₂Cu₃O_{d}, HoBa₂Cu₃O_{d}, and ErBa₂CU₃O_{d}. A superconducting phase i.e., the 123 phase is preferentially formed and grown from this nucleation site.

### Step 4

The shaped body with the nucleants placed on or embedded in it, or nothing on it, is heated at a temperature lying in the range of 950 to 1,250°C at which the 211 phase forms, and then retained at that temperature for 15 to 90 minutes, from which it is cooled down to a temperature somewhat higher than the temperature at which the 123 phase mentioned above starts to form from the 211 and liquid phases mentioned above, e.g., to a temperature somewhat higher than 1,000°C when RE is Y and the atmosphere is air, at a cooling rate of 10 to 1,000°C per hour. Subsequently, the shaped body is slowly cooled from this temperature down to 850 to 950°C at a cooling rate of 0.2 to 20°C per hour. Why the slow cooling is done from the temperature mentioned above is that when this temperature is low, the 123 phase is most likely to form wherever it forms. It is desired that the low cooling be carried out with some temperature gradients. In this case, it is preferable that a temperature gradient of 1°C/cm or more is set around the location of the shaped body on or in which the nucleants are placed or embedded, whereby the temperature of that location is low.

### Step 5

Following Step 4, the product may be cooled from 850 to 950°C down to room temperature at any desired cooling rate.

If required, the thus fabricated superconductor may be retained at a temperature lying in the range of 650 to 300°C for 2 to 500 hours, or may be cooled from a high of 650°C to a low of 300°C over 2 to 500 hours, in an oxygen-enriched atmosphere, thereby adding sufficient oxygen thereto. After this, it may be cooled at any desired cooling rate.

This makes it possible to obtain a superconductor which has large magnetic levitation force or a high critical current density.

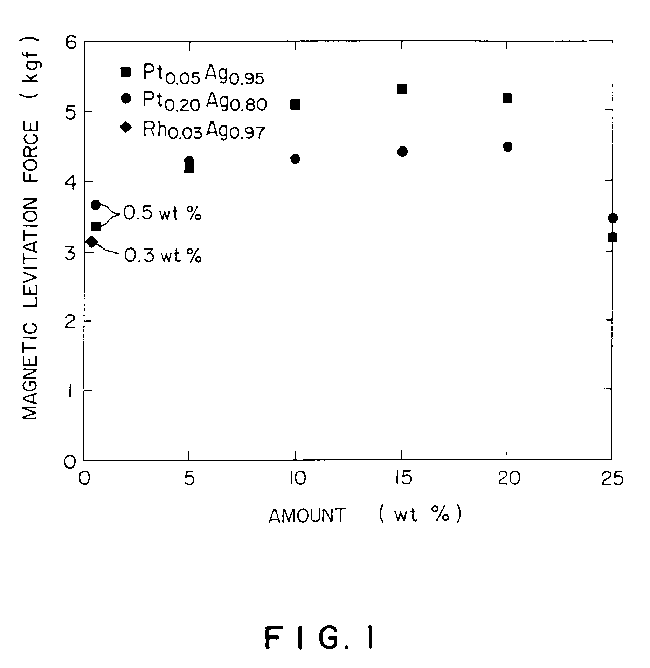

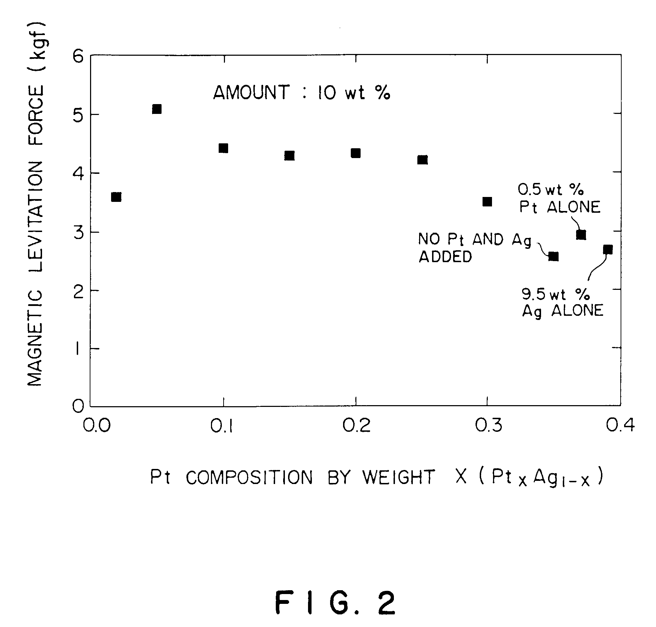

Fig. 1 is a graphical representation showing the relation between the amount of the additive containing platinum and silver at weight ratios of 5:95 and 20:80 and the magnetic levitation force of the superconductors produced with such an additive. The magnetic levitation force of the superconductor obtained with the addition of 0.3% by weight of the additive containing rhodium and silver at a weight ratio of 3:97 is also shown in Fig. 1. Fig. 2 is a graphical representation that illustrates a change in the magnetic levitation forces of superconductors fabricated with the use of additives composed basically of both platinum and silver but containing platinum in varying amounts. For the purpose of comparison, the magnetic levitation forces of superconductors fabricated in the absence of platinum and silver, and with either one of them, are also shown in Fig. 2. From the results shown in Fig. 2, it will be appreciated that larger magnetic levitation force can be obtained when both platinum and silver are used as the additive, as intended in the invention, than when platinum and/or silver are not used.

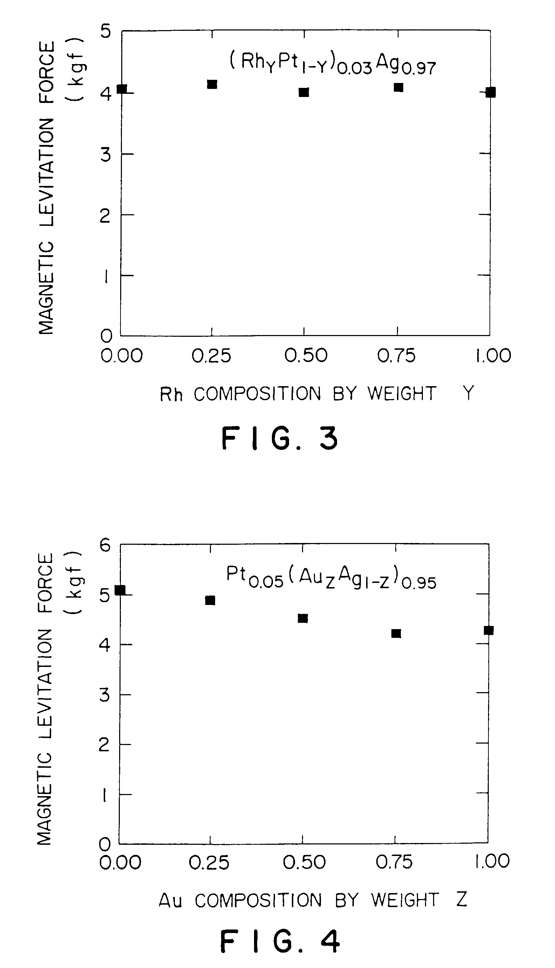

Fig. 3 is a graphical representation showing a change in the magnetic levitation force of superconductors obtained with the additive comprising platinum-rhodium systems containing varying amounts of rhodium, and silver, and Fig. 4 is a graphical representation showing a change in the magnetic levitation force of superconductors obtained with the additive comprising silver-gold systems containing varying amounts of gold, and platinum.

From these figures, it is found that superconductors having larger magnetic levitation force can be obtained according to the invention.

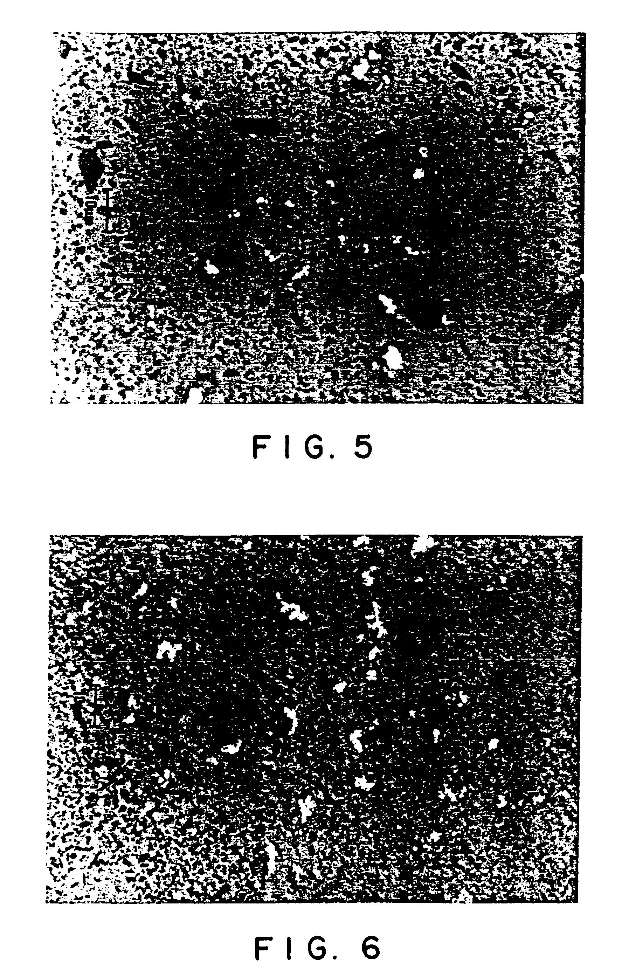

Figs. 5 and 6 are microphotographs showing the structures of superconductors obtained with the use of platinum and silver, as intended in the invention. In either case, it can be seen that the non-superconductive or 211 phase and platinum-silver alloy are finely dispersed throughout the 123 phase.

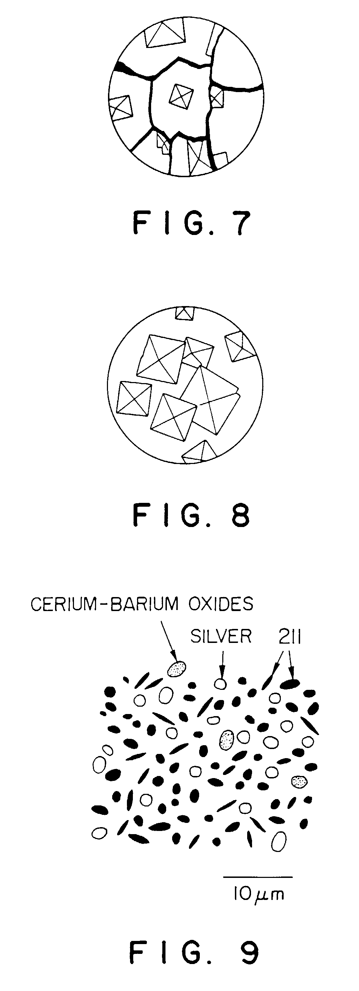

Fig. 8 is a sketch of superconductor pellets produced by adding 0.5 wt.% of CeO₂ and 10 wt.% of Ag. It will be seen that large, crack-free crystals could be obtained. On the other hand, Fig. 7 is a sketch of superconductor pellets produced by adding 0.5 wt.% of CeO₂ alone contrary to the teaching of the present invention. In this case, it will be seen that considerable cracks occurred and crystals could not become larger because of prevention by the above cracks.

Fig. 9 is a sketch of the structure of a superconductor produced by adding 0.5 wt.% of CeO₂ and 10 wt.% of Ag. A matrix phase is the 123 phase. It will be seen that a barium oxide and silver and the 211 phase were finely dispersed in the 123 phase.

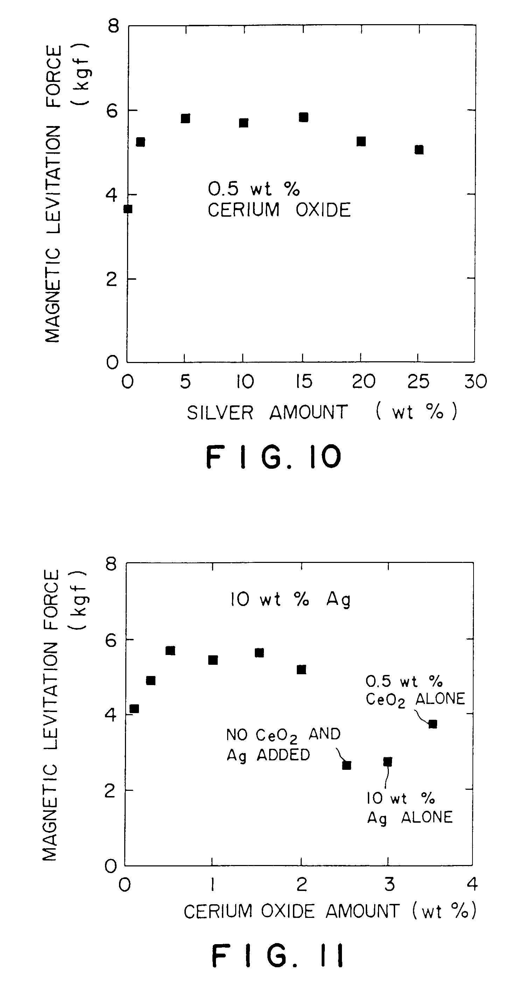

Fig. 10 is a graph showing the change of magnetic levitation force of the superconductor produced with the addition of 0.5 wt.% of CeO₂ and a various amount of Ag. It will be evident that the superconductor having large magnetic levitation force could be obtained with the addition of both of cerium oxide and silver according to the present invention.

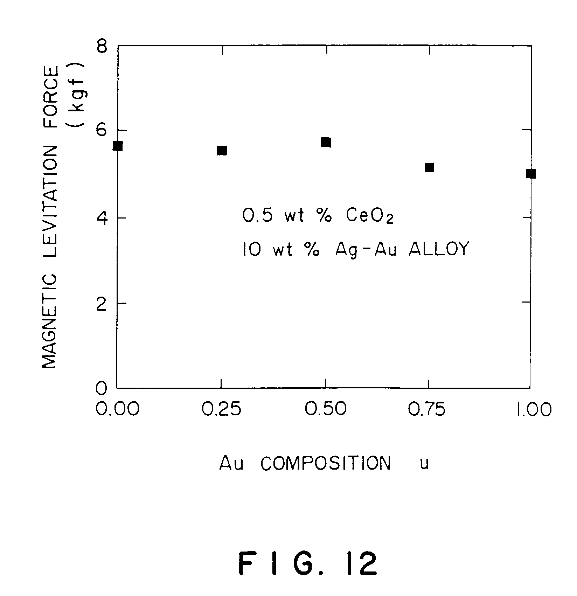

Fig. 11 is a graph showing the relation between the content of cerium oxide and the magnetic levitation force of the superconductor produced with the addition of 10 wt.% of silver and various amounts of cerium oxide. In this graph, the magnetic levitation forces of the superconductor obtained when both cerium oxide and silver were lack, when cerium oxide alone was used and when the silver alone was used, as the additives, were also shown for comparison. It is evident from these results that the superconductor having large magnetic levitation force can be obtained when both of cerium oxide and silver were added according to the present invention, compared with the cases when both of cerium oxide and silver were lack and when only either one of cerium oxide and silver was added.

Fig. 12 is a graph showing the relation between the content of gold in the Ag-Au alloy and the magnetic levitation force of the superconductor obtained with the addition of a 5 wt.% of cerium oxide and 10 wt.% of the above alloy.

It will be evident from these graphs that the superconductors having large magnetic levitation force can be obtained according to the present invention.

### EXAMPLES

The following examples and comparative examples are intended to illustrate the invention and not to limit the scope of the invention in all its aspects. First, the first aspect of the invention will be explained with reference to Comparative Example 1 and Examples 1 to 14.

### Comparative Example 1

Three powder feeds containing 0.5% by weight of platinum alone and 9.5% by weight of silver alone, and containing no additive were prepared.

More specifically, the raw powders, YBa₂Cu₃O_{d} and Y₂CuBaO₅, were mixed together at a Y:Ba:Cu ratio of 1.8:2.4:3.4. Following this, the mixture was well mixed with the above amounts of the above additives.

Each of the resulting mixtures was then shaped into a given shape, and this shape was in turn heated at 1,100°C for 60 minutes for separation into the 211 and liquid phases, which were cooled down to 1,000°C over 10 minutes. After this, the product was slowly cooled down to 870°C at 1°C per hour, followed by furnace cooling. The product was further heated at 600°C for 1 hour in a 1-atm oxygen stream, and finally subjected to oxygen annealing with furnace cooling to make a superconductor pellet of about 35 mm in diameter and about 13 mm in height.

These superconductor pellets were measured as to their magnetic levitation forces, using a permanent magnet having a diameter of 32 mm and a surface flux density of 0.4 T (tesla). As set out in Table 1, all these pellets had a magnetic levitation force as low as 3 kfg or below. The results are also illustrated in Fig. 2 for the purpose of comparison.

### Example 1

The raw powders, YBa₂Cu₃O_{d} and Y₂CuBaO₅, were mixed together at a molar Y:Ba:Cu ratio of 1.8:2.4:3.4. Following this, the resulting mixture was well mixed with 0.5, 5, 10, 15, 20, and 25% by weight of platinum-silver alloy powders having a Pt_{0.05}Ag_{0.95} composition by weight, and 0.3% by weight of Rh_{0.03}Ag_{0.97} alloy powders. Each of the mixtures was shaped into a given shape, and this shape was then heat-treated and oxygen-annealed, following the procedure of Comparative Example 1, thereby making a superconductor pellet. Pellet size was the same as in Comparative Example 1.

The structure of the superconductor fabricated with the raw powders containing 10% by weight of the platinum-silver alloy powders having a Pt_{0.05}Ag_{0.95} composition by weight was observed with a polarizing microscope, and its photograph is attached hereto - Fig. 5. As will be seen, the 211 phase and the platinum-silver alloy are finely dispersed through the 123 phase.

The magnetic levitation forces of these pellets were measured, following the procedure of Comparative Example 1. As shown in Fig. 1, the magnetic levitation forces of the pellets fabricated in this example are superior to that of Comparative Example 1.

### Example 2

The raw powders, YBa₂Cu₃O_{d} and Y₂BaCuO₅, were mixed together at a molar Y:Ba:Cu ratio of 1.8:2.4:3.4. Following this, the mixture was well mixed with the same amounts, as in Example 1, of platinum-silver alloy powders having a Pt_{0.20}Ag_{0.80} composition by weight. Each of the resulting mixtures was shaped into a given shape, and this shape was then heat-treated and oxygen-annealed, following the procedure of Comparative Example 1, thereby making a superconductor pellet. Pellet size was the same as in Comparative Example 1.

These pellets were measured as to their magnetic levitation forces, following the procedure of Comparative Example 1. The results again illustrated in Fig. 1 indicate that the pellets fabricated in this example are superior in magnetic levitation force to that of Comparative Example 1.

### Example 3

The raw powders, YBa₂Cu₃O_{d} and Y₂CuBaO₅, were mixed together at a molar Y:Ba:Cu ratio of 1.8:2.4:3.4. The mixture was well mixed with mixtures of platinum-silver powders having a PtₓAg₁₋ₓ by weight where x is 0.02, 0.05, 0.1, 0.15, 0.2, 0.25, and 0.3. These powder mixtures were added to the raw powders in an amount of 10% by weight. Each of the resulting mixtures was shaped into a given shape, and this shape was heat-treated and oxygen-annealed, following the procedure of Example 1, thereby making a superconductor pellet. Pellet size was the same as in Comparative Example 1.

These pellets were measured as to their magnetic levitation forces, following the procedure of Comparative Example 1.

As will be seen from Fig. 2, the pellets containing the compositions PtₓAg₁₋ₓ by weight wherein x lies in the range of 0.02 to 0.30 are superior in magnetic levitation force to that according to Comparative Example 1.

### Example 4

The raw powders, YBa₂Cu₃O_{d} and Y₂BaCuO₅, were mixed together at a molar Y:Ba:Cu ratio of 1.8:2.4:3.4. The mixture was well mixed with 10% by weight of mixtures of platinum-silver powders having a (Rh_{y}Pt_{1-y})_{0.03}Ag_{0.97} composition by weight where y is 0, 0.25, 0.75, and 1. Each of the resulting mixtures was shaped into a given shape, and this shape was heat-treated and oxygen-annealed, following the procedure of Example 1, thereby making a superconductor pellet. Pellet size was the same as in Comparative Example 1.

These pellets were measured as to their magnetic levitation forces, following the procedure of Comparative Example 1. It is consequently found that all the pellets fabricated in this example had a magnetic levitation force value of 4 kgf or more, as illustrated in Fig. 3.

### Example 5

The raw powders, YBa₂Cu₃O_{d} and Y₂BaCuO₅, were mixed together at a molar Y:Ba:Cu ratio of 1.8:2.4:3.4. Thereafter, the mixture was well mixed with 10% by weight of mixtures of platinum-silver-gold powders having a Pt_{0.05}(Au_{z}Ag_{1-z})_{0.95} composition by weight where z is 0, 0.25, 0.75, and 1. Each of the resulting mixtures was shaped into a given shape, and this shape was heat-treated and oxygen-annealed, following the procedure of Example 1, thereby making a superconductor pellet. Pellet size was the same as in Comparative Example 1.

These pellets were measured as to their magnetic levitation forces, following the procedure of Comparative Example 1. It is consequently found that all the pellets fabricated in this example had a magnetic levitation force value of 3.5 kgf or more, as illustrated in Fig. 4.

### Example 6

The raw powders, REBa₂Cu₃O_{d} and RE₂BaCuO₅, were mixed together at a molar RE:Ba:Cu ratio of 1.8:2.4:3.4. Thereafter, the mixture was well mixed with 10% by weight of a mixture of platinum-silver powders having a Pt_{0.05}Ag_{0.95} composition by weight. Following this, each of the resulting mixtures was shaped into a given shape, and this shape was then heat-treated and oxygen-annealed, following the procedure of Comparative Example 1, thereby fabricating a superconductor pellet. Pellet size was the same as in Comparative Example 1.

These pellets were measured as to their magnetic levitation forces, following the procedure of Comparative Example 1. It is thus noted that all the RE systems are superior in magnetic levitation force to Comparative Example 1, as set out in Table 2.

### Example 7

The raw powders, YBa₂Cu₃O_{d} and Y₂BaCuO₅, were mixed together at a molar RE:Ba:Cu ratio of 1.8:2.4:3.4. Thereafter, the mixture was well mixed with 10% by weight of a mixture of platinum-silver powders having a Pt_{0.05}Ag_{0.95} composition by weight. Following this, the resulting mixture was shaped into a given shape, and about 10 mg of a nucleants selected from Nd₂O₃, Sm₂O₃, and Eu₂O₃ powders was then placed on the center of the upper surface of this shape. The shape was then heated at 1,100°C for 60 minutes for separation into the 211 and liquid phases, which were in turn cooled down to 1,010°C over 10 minutes. Thereafter, the product was slowly cooled down to 870°C at 1°C per hour, followed by furnace cooling. The product was further heated at 600°C for 1 hour in a 1-atm oxygen stream, and finally subjected to furnace cooling to fabricate a superconductor pellet. Pellet size was the same as in Comparative Example 1.

These pellets were measured as to their magnetic levitation forces, following the procedure of Comparative Example 1. It is consequently found that all the pellets with the nucleants placed on them had a magnetic levitation force value as large as 5.8 kgf or more, as set out in Table 3.

### Example 8

Y₂O₃, BaCuO₂ and CuO powders were mixed together at a molar RE:Ba:Cu ratio of 1.8:2.4:3.4. Thereafter, the mixture was well mixed with 10% by weight of a mixture of platinum-silver powders having a Pt_{0.05}Ag_{0.95} composition by weight. Following this, the resulting mixture was shaped into a given shape, and about 10 mg of Nd₂O₃ powders was then embedded as the nucleants in the vertically central portion of one side of this shape. The shape was then heated at 1,100°C for 60 minutes for separation into the 211 and liquid phases, which were in turn cooled down to 1,040°C over 10 minutes. Thereafter, the product was slowly cooled down to 850°C at 1°C per hour and with a temperature gradient selected from 2°C/cm, 6°C/cm, and 10°C/cm in such a way that the temperature of the nucleants-embedded side of the product reached a low, followed by furnace cooling. The product was further heated at 600°C for 1 hour in a 1-atm oxygen stream, and finally subjected to furnace cooling to fabricate a superconductor pellet. Pellet size was the same as in Comparative Example 1.

These pellets were measured as to their magnetic levitation forces, following the procedure of Comparative Example 1. It is consequently found that the Nd₂O₃ powders embedded produce their own effect in the superconductors fabricated with some temperature gradients, as set out in Table 4.

### Example 9

Y₂O₃, BaCuO₂ and CuO powders were mixed together at a molar RE:Ba:Cu ratio of 1.8:2.4:3.4. Thereafter, the mixture was well mixed with 10% by weight of a mixture of platinum-silver powders having a Pt_{0.05}Ag_{0.95} composition by weight. Following this, the resulting mixture was shaped into a given shape, and about 10 mg of Nd₂O₃ powders was then placed as the nucleants on the center of the lower surface of this shape. The shape was then heated at 1,100°C for 60 minutes for separation into the 211 and liquid phases, which were in turn cooled down to 1,010°C over 10 minutes. Thereafter, the product was slowly cooled down to 890°C at 1°C per hour and with a temperature gradient of 1°C/cm in such a way that the temperature of the lower surface of the shape reached a low, followed by furnace cooling. The product was further heated at 600°C for 1 hour in a 1-atm oxygen stream, and finally subjected to furnace cooling to fabricate a superconductor pellet. Pellet size was the same as in Comparative Example 1.

These pellets were measured as to their magnetic levitation forces, according to the procedure of Comparative Example 1.

It is consequently found that the pellet with the Nd₂O₃ powders embedded therein has a magnetic levitation force value of 6.5 kgf.

### Example 10

Y₂O₃, BaCuO₂ and CuO powders were mixed together at a molar RE:Ba:Cu ratio of 1.8:2.4:3.4. Thereafter, the mixture was well mixed with 10% by weight of a mixture of platinum-silver powders having a Pt_{0.05}Ag_{0.95} composition by weight. Following this, the resulting mixture was pre-shaped with an uniaxial press, and then isotropically pressed at a pressure of 1,000 kg/cm² to obtain a compact of about 45 mm x about 45 mm x about 20 mm.

After pressing, the compact was heated at 1,100°C for 60 minutes, and then cooled down to 1,000°C over 10 minutes. Thereafter, the compact was slowly cooled down to 870°C at 1°C/cm, followed by furnace cooling. The compact was further heated at 600°C for 1 hour, and finally subjected to furnace cooling to fabricate a superconductor pellet.

For the purpose of comparison, a pellet was fabricated by uniaxial pressing at 1,000 kgf/cm² but without recourse to isotropic pressing. Other production conditions were the same as mentioned above.

These pellets were measured as to their magnetic levitation forces, following the procedure of Comparative Example 1.

It was consequently found that the superconductor pellet subjected to no isotropic pressing cracks with a magnetic levitation force as low as 5 kgf, whereas the isotropically pressed pellet undergoes no cracking with a magnetic levitation force as high as 6.5 kgf.

### Example 11

The raw powders, Y₂Cu₂O₅, BaO₂ and CuO were mixed together at a molar Y:Ba:Cu ratio of 1.8:2.4:3.4. Thereafter, the mixture was well mixed with 10% by weight of platinum-silver alloy powders having a Pt_{0.05}Ag_{0.95} composition by weight. After this, the mixture was shaped, and heat-treated and oxygen-annealed, following the procedure of Comparative Example 1 to fabricate a superconductor pellet. Pellet size was the same as in Comparative Example 1. The structure of the superconductor fabricated with the raw powders and 10% by weight of the Pt_{0.05}Ag_{0.95} alloy powders was observed with a polarizing microscope, and its photograph is attached hereto - Fig. 6.

As will be seen from this photograph, the phase 211 phase and the platinum-silver alloy are finely dispersed throughout the 123 phase, as is the case with Example 1. It is also observed that the size of the 211 phase is much smaller than that shown in Fig. 5.

As measured following the procedure of Comparative Example 1, these pellets are found to have a magnetic levitation force of 5.4 kgf.

### Example 12

The raw powders, YBa₂Cu₃O_{d} and Y₂BaCuO₅, were mixed together at a molar Y:Ba:Cu ratio of 1.8:2.4:3.4. Thereafter, 10% by weight of a mixture of platinum and silver powders having a Pt_{0.05}Ag_{0.95} composition was added to and well mixed with the resulting mixture. The mixture was further heated at 1,100°C for 30 minutes for partial melting, and the partial melt was then subjected to furnace cooling for solidification. The resulting solid body was subsequently pulverized and mixed, and then shaped into a given shape. The obtained shape was heated 1,100°C for 60 minutes for separation into the 211 and liquid phases, which were in turn cooled down to 1,000°C over 10 minutes. After this, the product was slowly cooled down to 870°C at 1°C per hour, followed by furnace cooling. The product was further heated at 600°C for 1 hour in a 1-atm oxygen stream, and finally subjected to furnace cooling to make a superconductor pellet. Pellet size was the same as in Comparative Example 1.

As measured following the procedure of Comparative Example 1, this pellet was found to have a magnetic levitation force as large as 5.1 kgf.

### Example 13

The raw powders, YBa₂Cu₃Od and Y₂BaCuO₅, were mixed together at a molar Y:Ba:Cu ratio of 1.8:2.4:3.4. Thereafter, 10% by weight of a mixture of platinum and silver powders having a Pt_{0.05}Ag_{0.95} composition was added to and well mixed with the resulting mixture. The thus prepared mixture was shaped, and then subjected to the same heat treatment and oxygen annealing as in Comparative Example 1, thereby making a superconductor pellet. Pellet size was the same as in Comparative Example 1.

This pellet was immersed in liquid nitrogen together with the Pt- and Ag-free pellet fabricated in Comparative Example 1 to measure their thermal conductivities. Upon a superconductor immersed in liquid nitrogen, the nitrogen bubbles, and upon the superconductor cooled down to the temperature of liquid nitrogen, bubbling is no longer found. Accordingly, different superconductors can be relatively compared with each other in terms of thermal conductivity by measuring the time during which nitrogen bubbles. The nitrogen bubbling time was 125 seconds for the Pt- and Ag-free superconductor, and 95 seconds for the Pt- and Ag-containing superconductor. It is therefore noted that the addition of platinum and silver contributes to some thermal conductivity increase.

### Example 14

The superconductors obtained and used in Example 13 were allowed to drop from a 1-mm height onto brick by gravity. It was consequently found that the Pt- and Ag-free superconductor fails, but the Pt- and Ag-containing superconductor does not.

**Table 1 -**

| Magnetic levitation force per additive | |
|---|---|
| Additive | Magnetic Levitation Force, kgf |
| - | 2.60 |
| 0.5 wt% Pt | 2.96 |
| 9.5 wt% Ag | 2.71 |

**Table 2 -**

| Magnetic levitation force per substituent | |
|---|---|
| Substituent for Y | Magnetic Levitation Force, kgf |
| Eu | 4.87 |
| Gd | 5.05 |
| Dy | 4.91 |
| Ho | 4.79 |
| Er | 5.01 |
| Yb | 4.65 |

**Table 3 -**

| Magnetic levitation force of pellets with nucleants placed on | |
|---|---|
| Nucleants | Magnetic Levitation Force, kgf |
| - | 5.09 |
| Nd₂O₃ | 5.85 |
| Sm₂O₃ | 5.91 |
| Eu₂O₃ | 5.55 |

**Table 4 -**

| Magnetic levitation force of pellets obtained by crystal grown with temperature gradient | |
|---|---|
| Temperature Gradient | Magnetic Levitation Force, kgf |
| - | 4.68 |
| 2°C/cm | 6.95 |
| 6°C/cm | 7.00 |
| 10°C/cm | 5.50 |

The following Comparative Example 2 and Examples 15 to 27 are intended to illustrate the second aspect of the invention.

### Comparative Example 2

Three powder feeds containing 0.5% by weight of cerium oxide alone and 10% by weight of silver alone, and containing no additive were prepared.

More specifically, the raw powders, YBa₂Cu₃O_{d} and Y₂BaCuO₅, were mixed together at a Y:Ba:Cu ratio of 1.8:2.4:3.4. Following this, the mixture was well mixed with the above amounts of the above additives.

Each of the resulting mixtures was then shaped into a given shape, and this shape was heated at 1,100°C for 60 minutes for separation into the 211 and liquid phases, which were cooled down to 1,000°C over 10 minutes. After this, the product was slowly cooled down to 870°C at 1°C per hour, followed by furnace cooling. The product was further heated at 600°C for 1 hour in a 1-atm oxygen stream, and finally subjected to oxygen annealing with furnace cooling to make a superconductor pellet of about 35 mm in diameter and about 13 mm in height.

The pellet containing cerium oxide alone cracked, and consisted of smaller superconducting crystals, because superconducting crystal growth was inhibited by the cracks. However, no crack was found in both the pellet containing silver alone and the pellet with no additive added thereto. The pellet containing cerium oxide alone is sketched in Fig. 7. As will be seen, some cracks occur, and inhibit crystal growth considerably.

These superconductor pellets were measured as to their magnetic levitation forces, using a permanent magnet having a diameter of 32 mm and a surface flux density of 0.4 T (tesla). As set out in Table 6, all these pellets had a magnetic levitation force as low as 3 kfg or below. The results are also illustrated in Fig. 11 for the purpose of comparison. It is noted, however, that the magnetic levitation force of the superconductor pellet containing cerium oxide alone is also in Fig. 10.

### Example 15

The raw powders, YBa₂Cu₃O_{d} and Y₂BaCuO₅, were mixed together at a molar Y:Ba:Cu ratio of 1.8:2.4:3.4. Following this, the resulting mixture was well mixed with 0.5% by weight of cerium oxide, and 1, 5, 10, 15, 20, and 25% by weight of silver. Each of the mixtures was shaped into a pellet, and this pellet was then heat-treated and oxygen-annealed, following the procedure of Comparative Example 2, thereby making a superconductor pellet. Pellet size was the same as in Comparative Example 2.

These pellets did not crack. The pellets with 0.5% by weight of cerium oxide and 10% by weight of silver added thereto are sketched in Fig. 8, from which it will be seen that larger crystals are obtainable due to the absence of cracks.

The structure of one pellet obtained in this example is sketched in Fig. 9. Note that the matrix phase is the 123 phase. As will be seen, the cerium-barium oxide, silver, and the 211 phase are finely dispersed throughout the 123 phase.

The magnetic levitation forces of these pellets were measured, following the procedure of Comparative Example 1. As shown in Fig. 10, the magnetic levitation forces of the pellets fabricated in this example are superior to that of Comparative Example 2.

### Example 16

The raw powders, YBa₂Cu₃O_{d} and Y₂BaCuO₅, were mixed together at a molar Y:Ba:Cu ratio of 1.8:2.4:3.4. Following this, 0.1, 0.3, 0.5, 1.0, 1.5, and 2.0% by weight of cerium oxide, and 10% by weight of silver were added to and well mixed with the resulting mixture. Each of the resulting mixtures was shaped into a given shape, and this shape was then heat-treated and oxygen-annealed, following the procedure of Comparative Example 2, thereby making a superconductor pellet. Pellet size was the same as in Comparative Example 2.

These pellets were measured as to their magnetic levitation forces, following the procedure of Comparative Example 2. The results again illustrated in Fig. 11 indicate that the pellets fabricated in this example are superior in magnetic levitation force to that of Comparative Example 2.

### Example 17

The raw powders, REBa₂Cu₃O_{d} and RE₂BaCuO₅, were mixed together at a molar RE:Ba:Cu ratio of 1.8:2.4:3.4. Thereafter, 0.5% by weight of cerium oxide, and 10% by weight of silver were added to and well mixed with the resulting mixture. Following this, each of the resulting mixtures was shaped into a given shape, and this shape was then heat-treated and oxygen-annealed, following the procedure of Comparative Example 2, thereby fabricating a superconductor pellet. Pellet size was the same as in Comparative Example 2.

These pellets were measured as to their magnetic levitation forces, following the procedure of Comparative Example 2. It is thus noted that all the RE systems are superior in magnetic levitation force to Comparative Example 2, as set out in Table 7.

### Example 18

The raw powders, YBa₂Cu₃O_{d} and Y₂BaCuO₅, were mixed together at a Y:Ba:Cu ratio of 1.8:2.4:3.4. Thereafter, 0.5% by weight of cerium oxide and 10% by weight of a silver-gold alloy having an AuᵤAg₁₋ᵤ composition by weight, wherein u is 0, 0.25, 0.5, 0.75, and 1.0, were added to and well mixed with the resulting mixture.

Each of the obtained mixtures was shaped and heated at 1,100°C for 60 minutes for separation into the 211 and liquid phases, which were slowly cooled down to 870°C at 1°C per hour, followed by furnace cooling. The product was further heated at 600°C for 1 hour in a 1-atm oxygen stream, and finally subjected to furnace cooling to make a superconductor pellet. Pellet size was the same as in Comparative Example 2.

As measured following the procedure of Comparative Example 2, all these pellets were found to be superior in magnetic levitation force than that of Comparative Example 2, as shown in Fig. 12.

### Example 19

The raw powders, YBa₂Cu₃O_{d} and Y₂BaCuO₅, were mixed together at an RE:Ba:Cu ratio of 1.8:2.4:3.4. Thereafter, 0.5% by weight of cerium oxide, and 10% by weight of silver oxide were added to and well mixed with the resulting mixture. Following this, the resulting mixture was shaped into a given shape, and about 10 mg of nucleants selected from Nd₂O₃, Sm₂O₃, and Eu₂O₃ powders were then placed on the center of the lower surface of this shape. The shape was then heated at 1,100°C for 60 minutes for separation into the 211 and liquid phases, which were in turn cooled down to 1,010°C over 10 minutes. Thereafter, the product was slowly cooled down to 870°C at 1°C per hour, followed by furnace cooling. The product was further heated at 600°C for 1 hour in a 1-atm oxygen stream, and finally subjected to furnace cooling to fabricate a superconductor pellet. Pellet size was the same as in Comparative Example 2.

These pellets were measured as to their magnetic levitation forces, following the procedure of Comparative Example 2. It was consequently found that all the pellets with the nucleants placed on them are superior in magnetic levitation force to that of Comparison Example 2, as set out in Table 3.

### Example 20

Y₂O₃, BaCuO₂ and CuO powders were mixed together at a Y:Ba:Cu ratio of 1.8:2.4:3.4. Thereafter, 0.5% by weight of cerium oxide and 10% by weight of silver were added to and well mixed with the resulting mixture. Following this, the obtained mixture was shaped into a given shape, and about 10 mg of Nd₂O₃ powders was then embedded as the nucleants in the vertically central portion of one side of this shape. The shape was then heated at 1,100°C for 60 minutes for separation into the 211 and liquid phases, which were in turn cooled down to 1,040°C over 10 minutes. Thereafter, the product was slowly cooled down to 850°C at 1°C per hour and with a temperature gradient selected from 2°C/cm, 6°C/cm, and 10°C/cm in such a way that the temperature of the nucleator-embedded side of the product reached a low, followed by furnace cooling. The product was further heated at 600°C for 1 hour in a 1-atm oxygen stream, and finally subjected to furnace cooling to fabricate a superconductor pellet. Pellet size was the same as in Comparative Example 1. These pellets were measured as to their magnetic levitation forces, following the procedure of Comparative Example 2. It is consequently found that the Nd2O3 powders embedded produce their own effect in the superconductors fabricated with some temperature gradients, as set out in Table 4.

### Example 21

Y₂O₃, BaCuO₂ and CuO powders were mixed together at a Y:Ba:Cu ratio of 1.8:2.4:3.4. Thereafter, 0.5% by weight of cerium oxide and 10% by weight of silver oxide were added to and well mixed with the resulting mixture. Following this, the obtained mixture was shaped into a given shape, and about 10 mg of Nd2O3 powders was then placed as the nucleants on the center of the lower surface of this shape. The shape was then heated at 1,100°C for 60 minutes for separation into the 211 and liquid phases, which were in turn cooled down to 1,020°C over 10 minutes. Thereafter, the product was slowly cooled at 1°C per hour and with a temperature gradient of 1°C/cm in such a way that the temperature of the nucleant-embedded side of the shape reached a low, followed by furnace cooling. The product was further heated at 600°C for 1 hour in a 1-atm oxygen stream, and finally subjected to furnace cooling to fabricate a superconductor pellet. Pellet size was the same as in Comparative Example 2. These pellets were measured as to their magnetic levitation forces, following the procedure of Comparative Example 1. It is consequently found that these pellet have a magnetic levitation force value of 8.5 kgf.

### Example 22

Y₂O₃, BaCuO₂ and CuO powders were mixed together at a Y:Ba:Cu ratio of 1.8:2.4:3.4. Thereafter, 0.5% by weight of cerium oxide and 10% by weight of silver were added to and well mixed with the resulting mixture. Following this, the obtained mixture was shaped, and then subjected to the same heat treatment and oxygen annealing as in Comparative Example 2, thereby making a superconductor pellet. Pellet size was the same as in Comparative Example 2.

As measured following the procedure of Comparative Example 2, all these pellets were found to have a magnetic levitation force of 5.8 kgf.

### Example 23

The raw powders, YBa₂Cu₃O_{d} and Y₂BaCuO₅, were mixed together at a Y:Ba:Cu ratio of 1.8:2.4:3.4. Thereafter, 0.5% by weight of cerium oxide and 10% by weight of silver were added to and well mixed with the resulting mixture. The obtained mixture was shaped and heated at 1,100°C for 30 minutes for partial melting, and the partial melt was then subjected to furnace cooling for solidification. The resulting solid body was subsequently pulverized and mixed, and then shaped into a given shape. The obtained shape was heated 1,100°C for 60 minutes for separation into the 211 and liquid phases, which were in turn cooled down to 1,000°C over 10 minutes. After this, the product was slowly cooled down to 870°C at 1°C per hour, followed by furnace cooling. The product was further heated at 600°C for 1 hour in a l-atm oxygen stream, and finally subjected to furnace cooling to make a superconductor pellet. Pellet size was the same as in Comparative Example 2.

As measured following the procedure of Comparative Example 2, this pellet was found to have a magnetic levitation force as large as 6.0 kgf.

### Example 24

The raw powders, YBa₂Cu₃O_{d} and Y₂BaCuO₅, were mixed together at a molar Y:Ba:Cu ratio of 1.8:2.4:3.4. Thereafter, 0.5% by weight of cerium oxide and 10% by weight of silver was added to and well mixed with the resulting mixture. The thus prepared mixture was calcined at 920°C for 24 hours, pulverized and mixed, and then shaped into a given shape. The shape was heated at 1,100°C for 60 minutes for sepration into the 211 and liquid phases by partial melting, which were in turn cooled down to 1,000°C at 1°C per hour, followed by furnace cooling. The product was further heated at 600°C for 1 hour in a 1-atm oxygen stream, and finally subjected to furnace cooling to make a superconductor pellet. Pellet size was the same as in Comparative Example 2.

This pellet was found to have a magnetic levitation force as large as 5.8 kgf, as measured according to Comparative Examle 2.

### Example 25

The raw powders, Y₂Cu₂O₅, BaO₂ and CuO, were mixed together at a Y:Ba:Cu ratio of 1.8:2.4:3.4. Thereafter, 0.5% by weight of cerium oxide, and 10% by weight of silver were added to and well mixed with the resulting mixture. Following this, the obtained mixture was shaped, and subjected to the same heat treatment and oxygen annealing as in Comparative Example 2, thereby making a superconductor pellet. Pellet size was the same as in Comparative Example 2.

This pellet was found to have a magnetic levitation force as large as 6.1 kfg, as measured according to Comparative Example 2.

### Example 26

The raw powders, YBa₂Cu₃O_{d} and Y₂CuBaO₅, were mixed together at a Y:Ba:Cu ratio of 1.8:2.4:3.4. Thereafter, 0.5% by weight of cerium oxide and 10% by weight of silver were added to and well mixed with the resulting mixture. Following this, the obtained mixture was shaped, and then subjected to the same heat treatment and oxygen annealing as in Comparative Example 2, thereby making a superconductor pellet. Pellet size was the same as in Comparative Example 1.

This pellet was immersed in liquid nitrogen together with the cerium oxide- and silver-free pellet fabricated in Comparative Example 2 to measure their thermal conductivities. Upon a superconductor immersed in liquid nitrogen, the nitrogen bubbles, and upon the superconductor cooled down to the temperature of liquid nitrogen, bubbling is no longer found. Accordingly, different superconductors can be relatively compared with each other in terms of thermal conductivity by measuring the time during which nitrogen bubbles. The nitrogen bubbling time was 125 seconds for the cerium oxide- and silver-free superconductor, and 93 seconds for the cerium oxide- and silver-containing superconductor. It is therefore noted that the addition of cerium oxide and silver contributes to some thermal conductivity increase.

### Example 27

The superconductors obtained and used in Example 26 were allowed to drop from a 1-mm height onto brick by gravity. It was consequently found that the cerium oxide- and silver-free superconductor fails, but the cerium oxide- and silver-containing superconductor does not; that is, the addition of silver contributes to some improvement in mechanical properties.

**Table 5 -**

| Magnetic levitation force per additive | |
|---|---|
| Additive | Magnetic Levitation Force, kgf |
| - | 2.60 |
| 0.5 wt% CeO₂ | 3.68 |
| 9.5 wt% Ag | 2.71 |

**Table 6 -**

| Magnetic levitation force per substituent | |
|---|---|
| Substituent for Y | Magnetic Levitation Force, kgf |
| Eu | 5.28 |
| Gd | 5.35 |
| Dy | 5.47 |
| Ho | 5.36 |
| Er | 5.80 |
| Yb | 5.14 |

**Table 7 -**

| Magnetic levitation force of pellets with nucleants placed on | |
|---|---|
| Nucleants | Magnetic Levitation Force, kgf |
| - | 5.65 |
| Nd₂O₃ | 7.30 |
| Sm₂O₃ | 7.05 |
| Eu₂O₃ | 6.92 |

**Table 8 -**

| Magnetic levitation force of pellets obtained by crystal grown with temperature gradient | |
|---|---|
| Temperature Gradient | Magnetic Levitation Force, kgf |
| - | 5.18 |
| 2°C per hour | 8.16 |
| 6°C per hour | 8.00 |
| 10°C per hour | 7.85 |

## Claims

1. A REBaCuO oxide superconductor, where RE is a rare earth element from the group consisting of Y, Sm, Eu, Gd, Dy,Ho, Er and Yb, which is has a structure wherein an additive, optionally comprising a RE₂BaCuO₅ phase, is finely dispersed throughout a REBa₂Cu₃O_{d} phase, characterised in that said additive is selected from the group consisting of a) a (Pt, Rh)(Au, Ag) alloy and b) a mixture of Ce oxide and one element from the group consisting of Ag, Ag oxide, Au and an (Ag, Au) alloy.

2. A superconductor as claimed in Claim 1, wherein *said (Pt, Rh) (Au, Ag) alloy has the weight composition*
(Rh_{y}Pt_{1-y})ₓ(Au_{z}Ag_{1-z})₁₋ₓ
where x lies in the range of 0.02 to 0.30, and y and z each lie in the range of 0 to 1.00.

3. A superconductor as claimed in Claim 1, wherein *said (Pt, Rh)(Au, Ag) alloy is finely dispersed in the range of 0,3 to 25 % by weight.*

4. A superconductor as claimed in Claim 1, wherein the oxide of cerium is finely dispersed in the range of 0.1 to 2.0% by weight, calculated as cerium oxide.

5. A superconductor as claimed in Claim 1, wherein said (Ag, Au) alloy has the weight composition
AuᵤAg₁₋ᵤ
where u lies in the range of 0 to 1.0.

6. A superconductor as claimed in Claim 1, wherein said (Ag, Au) alloy is finely dispersed in the range of 1.0 to 25.0% by weight.

7. A superconductor as claimed in any one of Claims 1 - 6, wherein said RE₂BaCuO₅ is finely dispersed in the range of 5 to 60 mol%.

8. A superconductor as claimed in any one of Claims 1 -7, wherein said RE₂BaCuO₅ phase and said additive have each a particle diameter of 50 µm or less.

9. A method for producing a REBaCuO oxide superconductor, where RE stands for a rare earth element selected from the group consisting of Y, Sm, Eu, Gd, Dy, Ho, Er and Yb, by mixing together RE BaCuO, oxide raw materials and an additive finely dispersed throughout a REBa₂Cu₃O_{d} phase, shaping the mixture, partially melting the shaped body at a temperature in the range of 950 to 1250°C at which a RE₂BaCuO_{d} phase forms, cooling down the partial melt to a temperature somewhat higher than a temperature at which the REBa₂Cu₃O_{d} phase starts to form from the RE₂BaCuO_{d} phase and liquid phase, at a cooling rate of 10 to 1000°C per hour and slowly cooling down to 850 to 950°C at a cooling rate of 0.2 to 20°C per hour, for the formation and growth of the superconductor, characterized in that said additive is selected from the group consisting of a) a (Pt, Rh) (Au, Ag) alloy and b) a mixture of Ce oxide and one element from the group consisting of Ag, Ag oxide, Au and an (Ag, Au) alloy.

10. A method as claimed in Claim 9, wherein said (Pt, Rh) (Au, Ag) alloy has the weight composition
(Rh_{y}Pt_{1-y})ₓ(Au_{z}Ag_{1-z})₁₋ₓ
where x lies in the range of 0.02 to 0.30, and y and z each lie in the range of 0 to 1.00.

11. A method as claimed in Claim 9, wherein said (Ag, Au) alloy is expressed by
AuᵤAg₁₋ᵤ
where u lies in the range of 0 to 1.0.

12. A method as claimed in Claim 9, wherein nucleants are placed on or embedded in said shaped body anytime between the completion of the shaping and the initiation of the slow cooling for superconductor phase formation and growth and after the mixing of said additive.

13. A method as claimed in Claim 12, wherein said nucleants are selected from the group consisting of Y₂O₃, Nd₂O₃, Sm₂O₃, Eu₂O₃, La₂O₃, Gd₂O₃, Dy₂O₃, Ho₂O₃, Er₂O₃, Y₂BaCuO₅, Sm₂BaCuO₅, Eu₂BaCuO₅, Gd₂BaCuO₅, Dy₂BaCuO₅, Ho₂BaCuO₅, Er₂BaCuO₅, YBa₂Cu₃O_{d}, NdBa₂Cu₃O_{d}, LaBa₂Cu₃O_{d}, EuBa₂Cu₃O_{d}, GdBa₂Cu₃O_{d}, DyBa₂Cu₃O_{d}, HoBa₂Cu₃O_{d}, and ErBa₂Cu₃O_{d}.

14. A method as claimed in Claim 9, wherein said slow cooling starts from a temperature somewhat higher than the temperature at which the REBa₂Cu₃O_{d} is formed from the RE₂BaCuO₅ and liquid phases which coexist at the time of the partial melting.

15. A method as claimed in Claim 12 , wherein powders or single crystals are used as the nucleants.

16. A method as claimed in Claim 9, wherein the temperature of the partial melting of said formed body is 950 to 1,250°C.

17. A method as claimed in Claim 9, wherein said slow cooling is carried out with a temperature gradient of 1°C/cm or more.

18. A method as claimed in claim 9 , wherein, after growth of the superconducting phase by said slow cooling, the thus fabricated superconductor is retained at a temperature lying in the range of 650 - 300°C for 2 to 500 hours, or is cooled from a high temperature of 650°C to a low temperature of 300°C over 2 to 500 hours, in an oxygen-enriched atmosphere.

## Patentansprüche

1. REBaCuO-Oxidsupraleiter mit RE als ein seltenes Erdeelement aus der Gruppe bestehend aus Y, Sm, Eu, Gd, Dy, Ho, Er und Yb, der eine Struktur hat, worin ein Zusatzstoff, wahlweise umfassend eine RE₂BaCuO₅-Phase, innerhalb einer REBa₂Cu₃O_{d}-Phase fein dispergiert ist, dadurch gekennzeichnet, daß dieser Zusatzstoff ausgewählt ist aus der Gruppe bestehend aus a) einer (Pt,Rh)(Au,Ag)-Legierung und b) einem Gemisch von Ca-Oxid und einem Element aus der Gruppe bestehend aus Ag. Ag-Oxid, Au und einer (Ag,Au)-Legierung.

2. Supraleiter nach Anspruch 1, worin die (Pt,Rh)( Au,Ag)-Legierung eine gewichtsmäßige Zusammensetzung hat
(Rh_{y}Pt_{1-y})ₓ(Au_{z}Ag_{1-z})₁₋ₓ
mit x im Bereich vom 0,02 bis 0,30 und y und z jeweils im Bereich von 0 bis 1,00.

3. Supraleiter nach Anspruch 1, worin die (Pt,Rh)(Au,Ag)-Legierung fein dispergiert ist in einem Bereich von 0.3 bis 25 Gewichtsprozent.

4. Supraleiter nach Anspruch 1, worin daß Ceroxid im Bereich von 0,1 bis 2,0 Gewichtsprozent bezogen auf Ceroxid fein dispergiert ist.

5. Supraleiter nach Anspruch 1, worin die (Ag,Au)-Legierung eine gewichtsmäßige Zusammensetzung hat
AuᵤAg₁₋ᵤ
mit u im Bereich von 0 bis 1,0.

6. Supraleiter nach Anspruch 1, worin die (Ag,Au)-Legierung im Bereich von 1.0 bis 25 Gewichtsprozent fein dispergiert ist.

7. Supraleiter nach einem der Ansprüche 1 bis 6, worin RE₂BaCuO₅ im Bereich von 5 bis 60 Molprozent fein dispergiert ist.

8. Supraleiter nach einem der Ansprüche 1 bis 7, worin die RE₂BaCuO₅-Phase und der Zusatzstoff jeweils eine Teilchengröße von 50 µm oder weniger haben.

9. Verfahren zur Herstellung eines REBaCuO-Oxidsupraleiters, wo RE ein seltenes Erdelement ausgewählt aus der Gruppe Y, Sm, Eu, Gd, Dy, Ho, Er und Yb ist, durch Mischen von REBaCuO, Oxidausgangsstoffe und einem fein innerhalb der REBa₂Cu₃O_{d}-Phase verteilten Zusatzstoff, ausformen der Mischung, teilweises Aufschmelzen des geformten Körpers bei einer Temperatur zwischen 950 und 1250 °C, bei der sich eine RE₂BaCuO_{d}-Phase ausbildet, abkühlen der Partialschmelze auf eine Temperatur etwas oberhalb der Temperatur, bei der sich die REBa₂Cu₃O_{d}-Phase aus der RE₂BaCuO_{d}-Phase und der flüssigen Phase zu bilden beginnt mit einer Abkühlgeschwindigkeit von 10 bis 1000 °C/h und langsames Abkühlen auf 850 bis 950 °C mit einer Abkühlungsgeschwindigkeit von 0,2 bis 20 °C/h zur Ausbildung und zum Wachstum des Supraleiters, dadurch gekennzeichent, daß der Zusatzstoff ausgewählt ist aus der Gruppe bestehend aus a) einer (Pt,Rh)(Au,Ag)-Legierungen und b) einem Gemisch von Ca-Oxid und einem Element aus der Gruppe bestehend aus Ag, Ag-Oxid, Au und einer (Ag,Au)-Legierung.

10. Verfahren nach Anspruch 9, worin die (Pt,Rh)(Au,Ag)-Legierung eine gewichtsmäßige Zusammensetzung hat
(Rh_{y}Pt_{1-y}) x (Au_{z}Ag_{1-z})₁₋ₓ
mit x im Bereich vom 0,02 bis 0,30 und y und z jeweils im Bereich von 0 bis 1,00.

11. Verfahren nach Anspruch 9, worin die (Ag,Au)-Legierung eine gewichtsmäßige Zusammensetzung hat
AuᵤAg₁₋ᵤ
mit u im Bereich von 0 bis 1,0.

12. Verfahren nach Anspruch 9, worin Keime auf den geformten Körper aufgebracht oder in denselben eingebettet werden, zu einem Zeitpunkt zwischen dem Abschluß der Formung und dem Beginn des langsamen Abkühlens zur Ausbildung der supraleitenden Phase und dem Wachsen der supraleitenden Phase und nach Einmischen des Zusatzstoffes.

13. Verfahren nach Anspruch 12, worin die Keime aus der Gruppe ausgewählt sind bestehend aus Y₂O₃, Nd₂O₃, Sm₂O₃, Eu₂O₃, La₂O₃, Gd₂O₃, Dy₂O₃, Ho₂O₃, Er₂O₃, Y₂BaCuO₅, Sm₂BaCuO₅, Eu₂BaCuO₅, Gd₂BaCuO₅, Dy₂BaCuO₅, Ho₂BaCuO₅, Er₂BaCuO₅, YBa₂Cu₃O_{d}, NdBa₂Cu₃O_{d}, LaBa₂Cu₃O_{d}, EuBa₂Cu₃O_{d}, GdBa₂Cu₃O_{d}, DyBa₂Cu₃O_{d}, HoBa₂Cu₃O_{d} und ErBa₂Cu₃O_{d}.

14. Verfahren nach Anspruch 9, worin die langsame Abkühlung von einer Temperatur etwas oberhalb derjenigen Temperatur bei der sich REBa₂Cu₃O_{d} aus RE₂BaCuO₅ und flüssigen Phasen ausbildet, die zur Zeit der partiellen Aufschmelzung koexistieren.

15. Verfahren nach Anpruch 12, worin Pulver oder Einkristalle als Keime benutzt werden.

16. Verfahren nach Anspruch 9, worin die Temperatur der Partialschmelze des geformten Körpers zwischen 950 und 1250 °C liegt.

17. Verfahren nach Anspruch 9, worin das langsame Abkühlen mit einem Temperaturgradient von 1 °C/cm oder mehr durchgeführt wird.

18. Verfahren nach Anspruch 9, worin nach dem Wachsen der supraleitenden Phase durch das langsame Abkühlen der erhaltene Supraleiter auf einer Temperatur im Bereich von 650 bis 300 °C für eine Zeitdauer von 2 bis 500 h gehalten oder von einer hohen Temperatur von 650 °C auf eine niedrige Temperatur von 300 °C während einer Zeitdauer von 2 bis 500 h in einer sauerstoffangereicherten Atmosphäre abgekühlt wird.

## Revendications

1. Un supraconducteur d'oxyde à REBaCuo, où RE est un élément de terre rare du groupe se composant de Y, Sm, Eu, Gd, Dy, Ho, Er et Yb, qui présente une structure dans laquelle un additif, comprenant facultativement une phase de RE₂BaCuO₅, est finement dispersé dans toute une phase de REBa₂Cu₃O_{d}, caractérisé en ce que ledit additif est choisi dans le groupe se composant de a) un alliage (Pt, Rh) (Au, Ag) et b) un mélange d'oxyde de Ce et d'un élément du groupe se composant de l'Ag, d'un oxyde d'Ag, de l'Au et d'un alliage (Ag, Au).

2. Un supraconducteur tel que revendiqué à la revendication 1, dans lequel ledit alliage (Pt, Rh) (Au, Ag) présente la composition pondérale
(Rh_{y} Pt_{1-y})ₓ (Au_{z} Ag_{1-z}) ₁₋ₓ
où x se trouve dans la gamme de 0,02 à 0,30, et y et z se trouvent chacun dans la gamme de 0 à 1,00.

3. Un supraconducteur tel que revendiqué à la revendication 1, dans lequel ledit alliage (Pt, Rh) (Au, Ag) est finement dispersé dans la gamme de 0,3 à 25 % en poids.

4. Un supraconducteur tel que revendiqué à la revendication 1, dans lequel l'oxyde de cérium est finement dispersé dans la gamme de 0,1 à 2,0 % en poids, calculé en tant qu'oxyde de cérium.

5. Un supraconducteur tel que revendiqué à la revendication 1, dans lequel ledit alliage (Ag, Au) présente la composition pondérale
Auᵤ Ag₁₋ᵤ
où u se trouve dans la gamme de 0 à 1,0.

6. Un supraconducteur tel que revendiqué à la revendication 1, dans lequel ledit alliage (Ag, Au) est finement dispersé dans la gamme de 1,0 à 25,0 % en poids.

7. Un supraconducteur tel que revendiqué dans une quelconque des revendications 1 à 6, dans lequel ledit RE₂BaCuO₅ est finement dispersé dans la gamme de 5 à 60 moles %.

8. Un supraconducteur tel que revendiqué dans une quelconque des revendications 1 à 7, dans lequel ladite phase de RE₂BaCuO₅ et ledit additif présentent chacun une granulométrie de 50 µm ou moins.

9. Un procédé de fabrication d'un supraconducteur d'oxyde à REBaCuO, où RE désigne un élément de terre rare choisi dans le groupe se composant de Y, Sm, Eu, Gd, Dy, Ho, Er et Yb, comprenant les opérations consistant à mélanger ensemble RE BaCuo, des matières brutes d'oxyde et un additif finement dispersé dans toute une phase de REBa₂Cu₃O_{d}, à mettre en forme le mélange, à faire partiellement fondre le corps conformé à une température dans la gamme de 950 à 1250°C à laquelle se forme une phase de RE2BaCuO_{d}, à refroidir le produit partiellement fondu à une température quelque peu plus élevée qu'une température à laquelle la phase de REBa₂Cu₃O_{d} commence à se former à partir de la phase de RE2BaCuO_{d} et de la phase liquide à une cadence de refroidissement de 10 à 1000°C par heure et à refroidir lentement de 850 à 950°C à une cadence de refroidissement de 0,2 à 20°C par heure, pour la fabrication et la croissance du supraconducteur, caractérisé en ce que ledit additif est choisi dans le groupe se composant a) d'un alliage (Pt, Rh) (Au, Ag) et b) d'un mélange d'oxyde de Ce et d'un élément du groupe se composant de l'Ag, d'un oxyde d'Ag, de l'Au et d'un alliage (Ag, Au).

10. Un procédé tel que revendiqué à la revendication 9, dans lequel ledit alliage (Pt, Rh) (Au, Ag) présente la composition pondérale
(Rh_{y} Pt_{1-y})₎ₓ (Au_{z} Ag_{1-z}) ₁₋ₓ
où x se trouve dans la gamme de 0,02 à 0,30, et y et z se trouvent chacun dans la gamme de 0 à 1,00.

11. Un procédé tel que revendiqué à la revendication 9, dans lequel ledit alliage (Ag, Au) est exprimé par
AuᵤAg₁₋ᵤ
où u se trouve dans la gamme de 0 à 1,0.

12. Un procédé tel que revendiqué à la revendication 9, dans lequel des nucléants sont placés sur ou incorporés dans ledit corps conformé à un moment quelconque entre l'achèvement de la mise en forme et le début du refroidissement lent pour la formation et la croissance de la phase supraconductrice et après le mélange dudit additif.

13. Un procédé tel que revendiqué à la revendication 12, dans lequel lesdits nucléants sont choisis dans le groupe se composant de Y₂O₃, Nd₂O₃, Sm₂O₃, Eu₂O₃, La₂O₃, Gd₂0₃, Dy₂O₃, Ho₂O₃, Er₂O₃, Y₂BaCuO₅, Sm₂BaCuO₅, Eu₂BaCuO₅, Gd₂BaCuO₅, Dy₂BaCuO₅, Ho₂BaCuO₅, Er₂BaCuO₅, YBa₂Cu₃O_{d}, NdBa₂Cu₃O_{d}, LaBa₂Cu₃O_{d}, EuBa₂Cu₃O_{d}, GdBa₂Cu₃O_{d}, DyBa₂Cu₃O_{d}, HoBa₂Cu₃O_{d} et ErBa₂Cu₃O_{d}.

14. Un procédé tel que revendiqué à la revendication 9, dans lequel ledit refroidissement lent commence à partir d'une température quelque peu plus élevée que la température à laquelle le REBa₂Cu₃O_{d} est formé à partir de la phase de RE₂BaCuO₅ et de la phase liquide qui coexistent au moment de la fusion partielle.

15. Un procédé tel que revendiqué à la revendication 12, dans lequel des poudres ou des cristaux uniques sont utilisés en tant que nucléants.

16. Un procédé tel que revendiqué à la revendication 9, dans lequel la température de la fusion partielle dudit corps conformé est de 950 à 1250°C.

17. Un procédé tel que revendiqué à la revendication 9, dans lequel ledit refroidissement lent est mis en oeuvre avec un gradient de température de 1°C/cm ou plus.

18. Un procédé tel que revendiqué à la revendication 9, dans lequel, après la croissance de la phase supraconductrice par ledit refroidissement lent, le supraconducteur ainsi réalisé est maintenu à une température se trouvant dans la gamme de 650 à 300°C pendant 2 à 500 heures, ou est refroidi à partir d'une température élevée de 650°C à une température basse de 300°C pendant 2 à 500 heures, dans une atmosphère enrichie en oxygène.
